# EUROPEAN PATENT APPLICATION

(11) **EP 3 023 631 A1**
(43) Date of publication of application: **25.05.2016**
(21) Application number: 15187612.5
(22) Date of filing: 30.09.2015
(51) Int. Cl.: F02P 23/04, H01S 1/02, H01S 3/16, G02B 19/00, G02B 6/00, G02B 27/09, G02B 27/30, H01S 3/08, H01S 3/094, H01S 3/0941, H01S 3/00

(54) **LASER DEVICE, IGNITION SYSTEM, AND INTERNAL COMBUSTION ENGINE**

(30) Priority: 30.09.2014 JP 2014200726; 19.08.2015 JP 2015161705
(71) Applicant: Ricoh Company, Ltd., Tokyo 143-8555 (JP)
(72) Inventor: Numata, Masayuki, Tokyo, 143-8555 (JP); Hagita, Kentaroh, Tokyo, 143-8555 (JP); Izumiya, Kazuma, Tokyo, 143-8555 (JP); Jikutani, Naoto, Tokyo, 143-8555 (JP); Higashi, Yasuhiro, Tokyo, 143-8555 (JP); Suzudo, Tsuyoshi, Tokyo, 143-8555 (JP)
(74) Representative: Maury, Richard Philip

(57) **Abstract**

A laser device (200) is provided including a light source (201) configured to emit light, a laser resonator (206) which the light emitted from the light source (201) enters, a first optical element (207a) configured to increase a divergence angle of the light emitted from the laser resonator (206), a second optical element (207b) configured to collimate the light whose divergence angle is increased by the first optical element (207a), and a third optical element (207c) configured to collect and condense the light collimated by the second optical element (207b).

## Description

### BACKGROUND

### Technical Field

Embodiments of the present invention relate to a laser device, an ignition system, and an internal combustion engine.

### Background Art

Laser devices with laser crystal that resonates by optical pumping are expected to be applied to various kinds of fields including, for example, ignition systems, laser beam machines, and medical equipment.

For example, JP-2009-538402-A discloses an ignition system for an internal combustion engine where a laser device includes at least one refractive device, the refractive device refracts at least some of pumping light, and the ignition system is integrated into the laser device.

However, it has proven difficult for conventional laser devices to achieve downsizing.

### SUMMARY

Embodiments of the present invention described herein provide a laser device including a light source configured to emit light, a laser resonator which the light emitted from the light source enters, a first optical element configured to increase a divergence angle of the light emitted from the laser resonator, a second optical element configured to collimate the light whose divergence angle is increased by the first optical element, and a third optical element configured to collect and condense the light collimated by the second optical element.

With the laser device according to an embodiment of the present invention, downsizing is achieved.

### BRIEF DESCRIPTION OF THE DRAWINGS

A more complete appreciation of exemplary embodiments and the many attendant advantages thereof will be readily obtained as the same becomes better understood by reference to the following detailed description when considered in connection with the accompanying drawings.
FIG. 1 is a diagram illustrating an outline of an engine according to an embodiment of the present invention.
FIG. 2 is a diagram illustrating an ignition system according to an example embodiment of the present invention.
FIG. 3 is a diagram illustrating a laser resonator according to an embodiment of the present invention.
FIG. 4 is diagram illustrating an emission optical system according to an embodiment of the present invention.
FIG. 5A and FIG. 5B are a set of diagrams illustrating a function of a first lens according to an example embodiment of the present invention.
FIG. 6A and FIG. 6B are another set of diagrams illustrating a function of a first lens according to an example embodiment of the present invention.
FIG. 7A and FIG. 7B are a set of diagrams illustrating the adjustment of the focal point of a third lens according to an example embodiment of the present invention.
FIG. 8A and FIG. 8B are a set of diagrams illustrating a function of a second lens according to an example embodiment of the present invention.
FIG. 9 is a diagram illustrating a modification of a laser device according to an embodiment of the present invention.

The accompanying drawings are intended to depict exemplary embodiments of the present disclosure and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present invention. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity. However, the present disclosure is not intended to be limited to the specific terminology so selected and it is to be understood that each specific element includes all technical equivalents that have the same structure, operate in a similar manner, and achieve a similar result.

A Q-switched laser enhances the population inversion in advance by the light emitted from a pump source, and generates energy by releasing the Q-switching elements. Accordingly, peak energy becomes high.

Due to such characteristics, Q-switched lasers are expected to be applied to an ignition system of an internal combustion engine having a combustion chamber where inflammable fuel-air mixture is to be ignited.

Currently, inflammable fuel-air mixture in a combustion chamber of an internal combustion engine is ignited mainly by a spark plug, i.e., spark ignition of electric discharge. However, in spark ignition, electrodes of a spark plug are exposed in a combustion chamber for the structural reasons. Accordingly, the erosion of the electrodes are inevitable. For this reason, the longevity of spark plugs is short when spark ignition of electric discharge is adopted.

By contrast, laser ignition is known where ignition is performed by collecting and condensing laser beam. In such laser ignition, no electrode is required, and electrodes are not exposed in a combustion chamber of an internal combustion engine. Accordingly, there is no need to concern about the erosion of electrodes, and the longevity of an ignition system can be increased.

However, in some known ignition systems, the distance between a laser device and a condenser lens is made long so as to stop down the laser beam emitted from the laser device by the condenser lens. In such cases, the ignition systems tend to be upsized, which is disadvantageous.

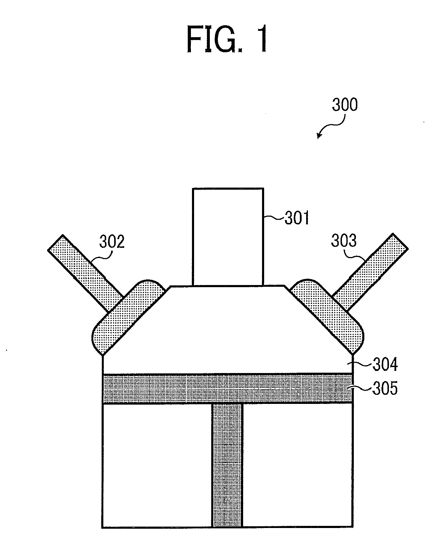

In the following description, some embodiments of the present invention are described with reference to FIG. 1 to FIG. 9. FIG. 1 is a schematic diagram illustrating the principal parts of an engine 300 that serves as an internal combustion engine, according to an embodiment of the present invention.

The engine 300 includes, for example, an ignition system 301, a fuel injector 302, an exhauster 303, a combustion chamber 304, and a piston 305.

The operation of the engine 300 is briefly described.
(1) The fuel injector 302 injects the inflammable fuel-air mixture into the combustion chamber 304 (aspiration).
(2) The piston 305 moves upward and compresses the inflammable fuel-air mixture (compression).
(3) The ignition system 301 emits laser beam into the combustion chamber 304. Accordingly, the fuel is ignited (ignition).
(4) Inflammable gas is generated and the piston 305 moves downward (combustion).
(5) The exhauster 303 exhausts the inflammable gas from the combustion chamber 304 (exhaust).

As described above, a series of processes including aspiration, compression, ignition, combustion, and exhaust are repeated. Then, the piston 305 moves upward and downward according to the changes in the volume of the gas in the combustion chamber 304, and kinetic energy is produced. As fuel, for example, natural gas and gasoline are used.

Note that the above operation of the engine 300 is performed based on the instruction made through an engine controller that is externally provided and is electrically connected to the engine 300.

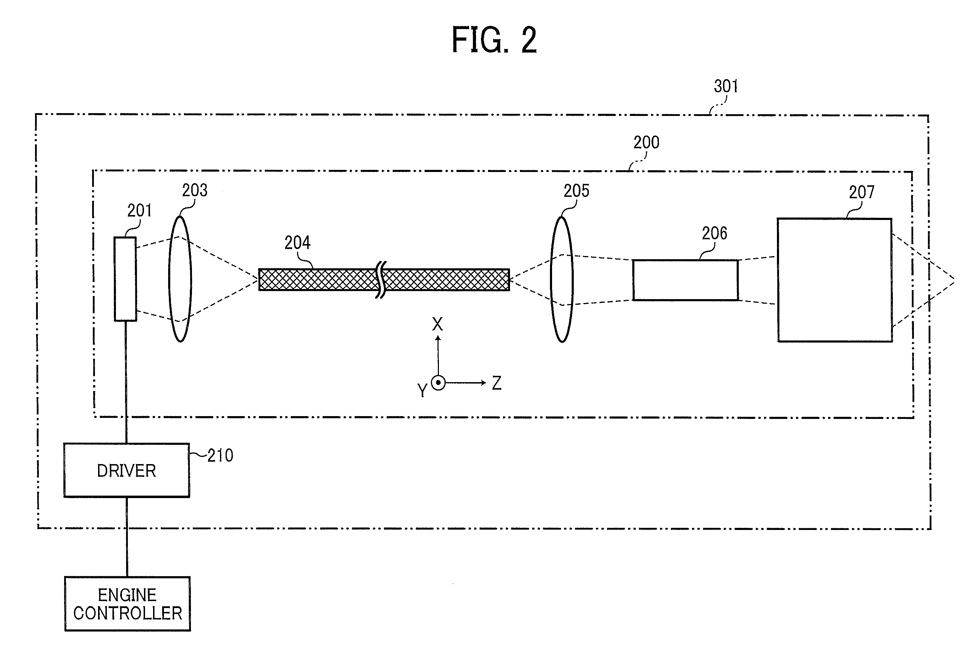

As illustrated in FIG. 2 for example, the ignition system 301 includes a laser device 200 and a driver 210.

The laser device 200 includes a surface emitting laser 201, a first condensing optical system 203, an optical fiber 204, a second condensing optical system 205, a laser resonator 206, and an emission optical system 207. In the XYZ three-dimensional orthogonal coordinate system according to the present embodiment, it is assumed that the direction in which the surface emitting laser 201 emits light is the +X direction.

The surface emitting laser 201 is vertical cavity-surface emitting laser (VCSEL). In the present embodiment, the surface emitting laser 201 is a pump source, and includes a plurality of light-emitting units. When the surface emitting laser 201 emits light, the multiple light-emitting units emit light at the same time.

Note that surface emitting lasers have very little temperature-driven wavelength displacement. Thus, a surface emitting laser is a light source that is advantageous in pumping Q-switched laser whose characteristics vary widely due to the wavelength displacement. Accordingly, when a surface emitting laser is used as a pump source, the temperature control of the environment becomes easier.

The first condensing optical system 203 is a condenser lens, and condenses the light emitted from the surface emitting laser 201. Note that the first condensing optical system 203 may include a plurality of optical elements.

The optical fiber 204 is disposed such that the light exited from the first condensing optical system 203 is condensed at the center of the -Z side lateral edge face of the core.

Due to the provision of the optical fiber 204, the surface emitting laser 201 may be disposed at a position distant from the laser resonator 206. Accordingly, the degree of flexibility in design increases. As the surface emitting laser 201 can be disposed at a position away from the heat source when the laser device 200 is used for an ignition system, the ranges of choices for a method for cooling the engine 300 can be extended.

The light that has entered the optical fiber 204 propagates through the core, and is exited from the +Z side lateral edge face of the core.

The second condensing optical system 205 is a condenser lens disposed in the optical path of the light emitted from the optical fiber 204, and condenses the light emitted from the optical fiber 204. Depending on the quality of the light or the like, the second condensing optical system 205 may include a plurality of optical elements. The light that has been condensed by the second condensing optical system 205 enters the laser resonator 206.

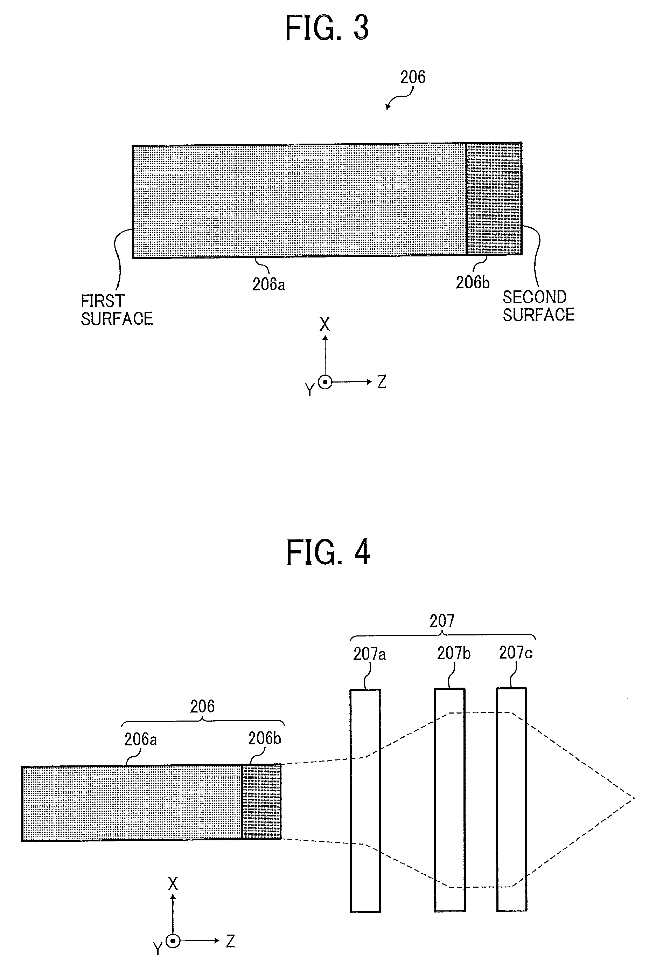

The laser resonator 206 is a Q-switched laser, and as illustrated in FIG. 3 for example, the laser resonator 206 includes a laser medium 206a and a saturable absorber 206b.

The laser medium 206a is a cuboid-shaped neodymium (Nd): yttrium aluminum garnet (YAG) ceramic crystal, where the length of the resonator is 8 mm. The saturable absorber 206b is a cuboid-shaped chromium (Cr): YAG ceramic crystal, where the length is 2 mm.

In the present embodiment, the Nd: YAG crystal and the Cr: YAG crystal are both ceramic. The laser resonator 206 is a so-called composite crystal in which the laser medium 206a and the saturable absorber 206b are bonded together.

The light that has been condensed by the second condensing optical system 205 enters the laser medium 206a. In other words, the laser medium 206a is optically pumped by the light that has been condensed by the second condensing optical system 205. It is desired that the wavelength of the light that is emitted from the surface emitting laser 201 be 808 nanometer (nm) where the absorption efficiency is the highest in the YAG crystal. The saturable absorber 206b performs Q-switching.

The surface on the light entering side (-Z side) of the laser medium 206a and the surface on the light exiting side (+Z side) of the saturable absorber 206b are optically polished, and each of these surfaces serves as a mirror. In the following description, for the sake of explanatory convenience, the surface on the light entering side of the laser medium 206a is referred to as a first surface, and the surface on the light exiting side of the saturable absorber 206b is referred to a second surface (see FIG. 3).

On the first and second surfaces, a dielectric multilayer is coated according to the wavelength of the light that is emitted from the surface emitting laser 201 and the wavelength of the light that exits from the laser resonator 206.

More specifically, a dielectric layer that indicates sufficient high transmittance to light with the wavelength of 808 nm and indicates sufficiently high reflectance to light with the wavelength of 1064 nm is coated on the first surface. On the second surface, a dielectric layer with selected reflectance indicating a desired threshold to light with the wavelength of 1064 nm is coated.

Accordingly, the light is resonated and amplified inside the laser resonator 206. In the present embodiment, the length of the laser resonator 206 is 10 (=8+2) mm.

As illustrated in FIG. 4 for example, the emission optical system 207 includes a first lens 207a, a second lens 207b, and a third lens 207c.

The first lens 207a is an optical element that increases the divergence angle of the light that is emitted from the laser resonator 206. In the present embodiment, for example, a concave lens is used.

The second lens 207b is an optical element that collimates the light diverging from the first lens 207a. In the present embodiment, for example, a collimator lens is used.

The third lens 207c is an optical element that collects and condenses the light exiting from the second lens 207b. In the present embodiment, for example, a both-side aspherical condenser lens is used. As the light is collected and condensed by the third lens 207c, a high energy density can be obtained at a focal point.

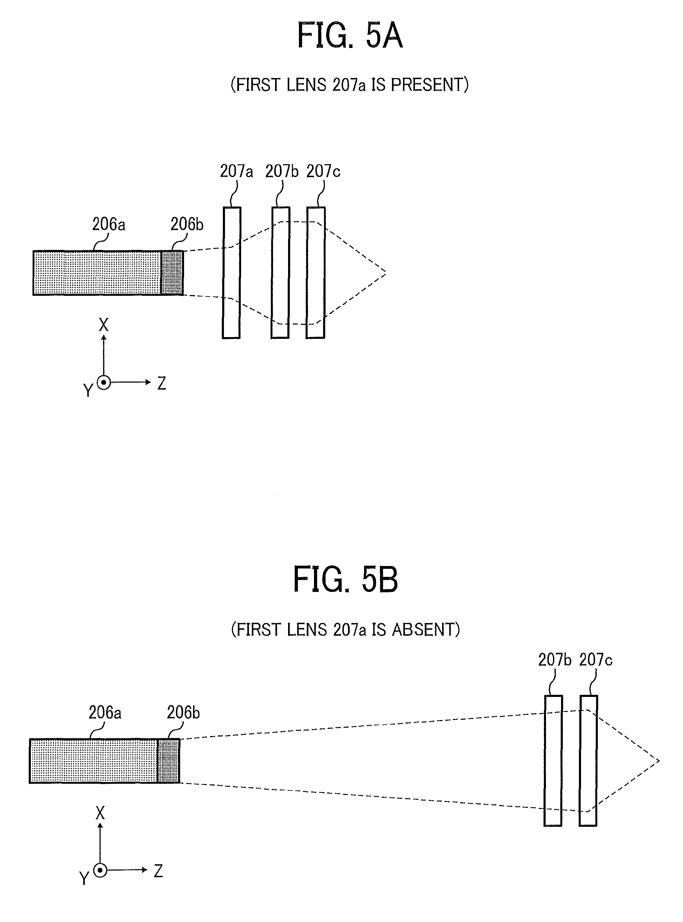

The first lens 207a shortens the distance between the laser resonator 206 and the third lens 207c (see FIG. 5A and FIG. 5B).

Even if the first lens 207a is absent, the third lens 207c can collect and condense the light that is emitted from the laser resonator 206. However, the light that exits from the laser resonator 206 has small angle of radiation. For this reason, without the first lens 207a, the distance between the laser resonator 206 and the third lens 207c becomes long. In such cases, the housing (plug) in which the laser resonator 206 and the emission optical system are accommodated tends to be upsized. This leads to an increase in the cost of manufacturing the housing and an increase in the size of the laser device or ignition system. When the size of the housing increases, the space in which the housing is disposed needs to be larger. Such an increase in size leads to low flexibility in the component arrangement of an apparatus for which the laser resonator 206 is provided.

In the present embodiment, the provision of the first lens 207a increases the divergence angle of the light exiting from the laser resonator 206, and thus the distance between the laser resonator 206 and the third lens 207c can be shortened. As a result, the housing can be downsized. In other words, the manufacturing cost of the housing can be reduced. Moreover, the flexibility in the component arrangement of an apparatus for which the laser resonator 206 is provided increases.

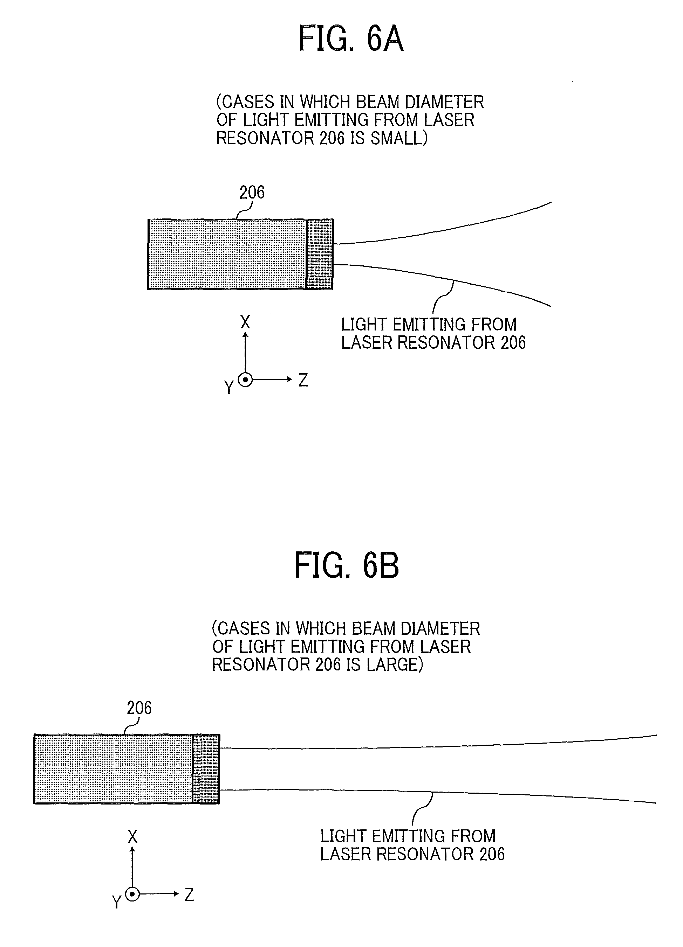

When the surface emitting laser includes a plurality of light-emitting units, the dimension of the light-emitting area is large, and thus the light that enters the laser resonator 206 has a wide beam diameter. When the light that enters the laser resonator 206 has a wide beam diameter with a similar M² value, the light that exits from the laser resonator 206 does not disperse as desired (see FIG. 6A and FIG. 6B), and the distance between the laser resonator 206 and the third lens 207c tends to be long. For these reasons, it is very much desired that the first lens 207a be provided for the emission optical system 207, in particular, when a surface emitting laser having a plurality of light-emitting units is used as a pump source.

As described above, in the present embodiment, the light that exits from the laser resonator 206 has a small M² value and has high beam quality. In such configuration, the provision of the first lens 207a is effective.

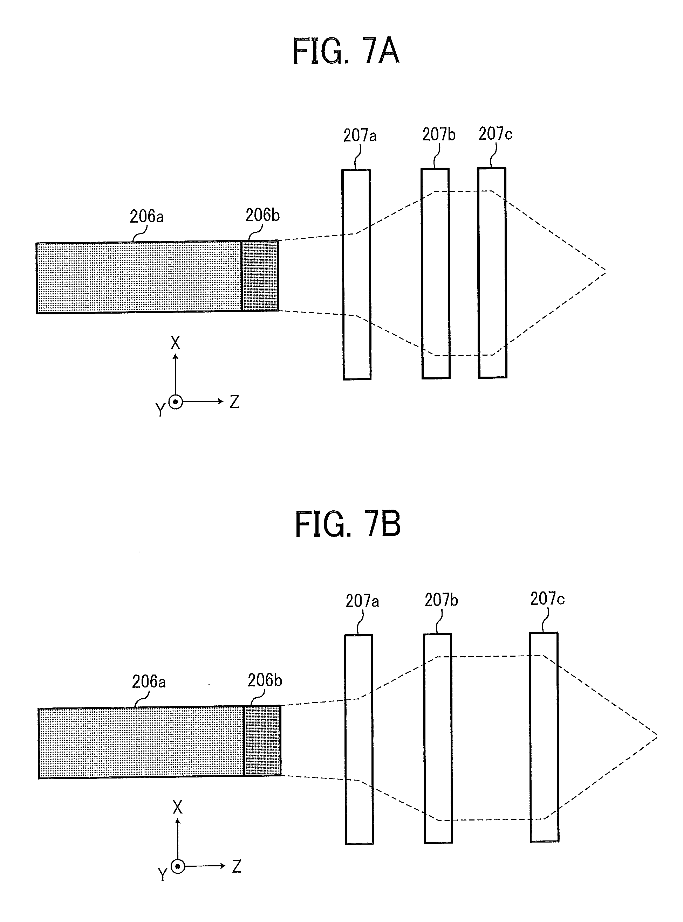

As the second lens 207b is provided for the emission optical system 207, the focal point of the light can be adjusted only by adjusting the position of the third lens 207c (see FIG. 7A and FIG. 7B).

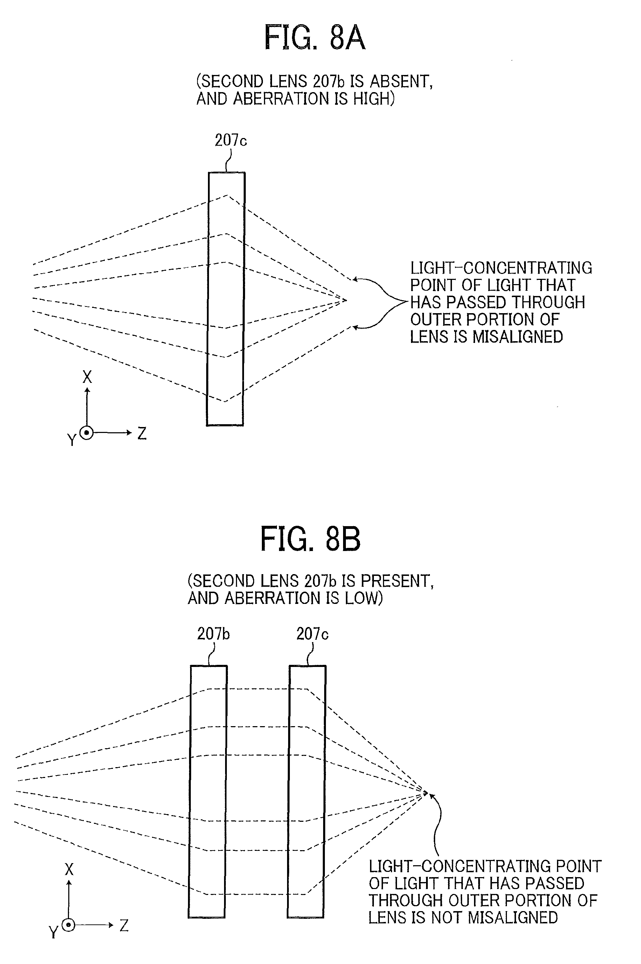

Further, as the aberration is small, even the light that passed through the outer portions of the third lens 207c can be collected and condensed at a desired position (see FIG. 8A and FIG. 8B). Accordingly, when the laser device 200 according to the present embodiment is used for an ignition system, ignition can efficiently be performed.

As illustrated in FIG. 2, the driver 210 drives the surface emitting laser 201 based on an instruction from an engine controller. More specifically, the driver 210 drives the surface emitting laser 201 such that the ignition system 301 emits light at the timing when the engine 300 performs ignition.

As described above, the surface emitting laser 201 serves as a light source in the laser device 200 according to the present embodiment of the present invention. The first lens 207a, the second lens 207b, and the third lens 207c form a first optical element, a second optical element, and a third optical element, respectively.

As described above, the laser device 200 according to the present embodiment includes the surface emitting laser 201, the first condensing optical system 203, the optical fiber 204, the second condensing optical system 205, the laser resonator 206, and the emission optical system 207.

The laser resonator 206 is a composite crystal of the laser medium 206a and the saturable absorber 206b.

The emission optical system 207 is disposed in the optical path of the light emitted from the laser resonator 206, and includes the first lens 207a, the second lens 207b, and the third lens 207c.

The first lens 207a increases the divergence angle of the light that is emitted from the laser resonator 206, and the second lens 207b collimates the light diverging from the first lens 207a. The third lens 207c collects and condenses the collimated light. By so doing, even when light with a small angle of radiation is emitted from the laser resonator 206, the distance between the laser resonator 206 and the third lens 207c can be shortened. Moreover, the focal point of the light that is emitted from the ignition system 301 can easily be adjusted.

Accordingly, the laser device can be downsized without degrading the focal point precision.

Due to the provision of the laser device 200, the ignition system 301 according to the present embodiment can be downsized. Moreover, unlike a spark plug of a spark-ignition method, it is not necessary for the ignition system 301 according to the present embodiment to expose an electrode in the combustion chamber, and thus the longevity of the ignition system 301 can be increased.

Due to the provision of the ignition system 301, the engine 300 according to the present embodiment can be downsized.

In the embodiments described above, cases in which a surface emitting laser is used as a pump source are described. However, no limitation is intended thereby. For example, an end-surface emitting laser may be used as a pump source.

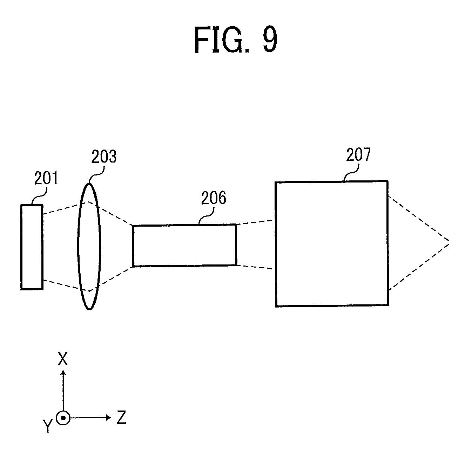

When it is not necessary to dispose the surface emitting laser 201 at a position distant from the laser resonator 206 in the embodiments described above, the provision of the optical fiber 204 may be omitted (see FIG. 9).

In the embodiments described above, cases of an engine (piston engine) where a piston is moved by inflammable gas is used as an internal combustion engine are described. However, no limitation is intended thereby. For example, a rotary engine, a gas turbine engine, and a jet engine may be used as an internal combustion engine. In other words, any engine may be used as long as it burns fuel to produce inflammable gas.

The ignition system 301 may be used for cogeneration in which exhaust heat is reused to increase the comprehensive energy efficiency. The exhaust heat in cogeneration is used for obtaining motive power, heating energy, or cooling energy.

In the embodiments described above, cases in which the ignition system 301 is used for an internal combustion engine are described. However, no limitation is intended thereby.

In the embodiments described above, cases in which the laser device 200 is used for an ignition system are described. However, no limitation is intended thereby. For example, the laser device 200 may be used for a laser beam machine, a laser peening apparatus, or a terahertz generator.

Numerous additional modifications and variations are possible in light of the above teachings. It is therefore to be understood that within the scope of the appended claims, the disclosure of the present invention may be practiced otherwise than as specifically described herein. For example, elements and/or features of different illustrative embodiments may be combined with each other and/or substituted for each other within the scope of this disclosure and appended claims.

## Claims

1. A laser device (200) comprising:
a light source (201) configured to emit light;
a laser resonator (206) which the light emitted from the light source (201) enters;
a first optical element (207a) configured to increase a divergence angle of the light emitted from the laser resonator (206);
a second optical element (207b) configured to collimate the light whose divergence angle is increased by the first optical element (207a); and
a third optical element (207c) configured to collect and condense the light collimated by the second optical element (207b).

2. The laser device of claim 1, wherein the first optical element (207a) is a concave lens.

3. The laser device (200) according to claim 1, wherein the third optical element (207c) is movable in a light emitting direction.

4. The laser device (200) according to any one of claim 1 to 3, wherein the laser resonator (206) is a Q-switched laser.

5. The laser device (200) according to any one of claims 1 to 4, further comprising:
a transmission member (204) disposed between the light source (201) and the laser resonator (206) to transmit the light from the light source (201) to the laser resonator (206).

6. The laser device (200) according to any one of claims 1 to 5, wherein the light source (201) is a surface emitting laser.

7. The laser device (200) according to any one of claims 1 to 6, wherein the laser resonator (206) is ceramic.

8. The laser device (200) according to any one of claims 1 to 7, wherein the laser resonator (206) is a composite crystal in which a laser medium and a saturable absorber are bonded together.

9. The laser device (200) according to claim 8, wherein
the laser medium is a YAG crystal where Nd is doped, and
the saturable absorber is a YAG crystal where Cr is doped.

10. An ignition system (301) comprising:
the laser device (200) according to any one of claims 1 to 9; and
a driver (210) configured to drive the light source (201) of the laser device (200).

11. An internal combustion engine (300) in which fuel is burnt to produce inflammable gas, the internal combustion engine (300) comprising: the ignition system (301) according to claim 10 which ignites the fuel.
